# EUROPEAN PATENT APPLICATION

(11) **EP 3 428 974 A1**
(43) Date of publication of application: **16.01.2019**
(21) Application number: 18729533.2
(22) Date of filing: 18.05.2018
(51) Int. Cl.: H01L 31/048

(54) **THIN FILM PHOTOVOLTAIC BATTERY ASSEMBLY**

(30) Priority: 19.05.2017 CN 201720562486 U
(71) Applicant: Miasole Photovoltaic Technology Co., Ltd., 100107 Beijing (CN)
(72) Inventor: ZHANG, Jinchun, Beijing 100070 (CN); YANG, Sheng, Beijing 100070 (CN)
(74) Representative: Cabinet Beau de Loménie
(86) International application number: PCT/CN2018/087536
(87) International publication number: WO 2018/210342

(57) **Abstract**

The disclosure provides a thin-film battery photovoltaic module, comprising a glass sheet (6), a front packaging plate (1) and a thin-film battery pack (3), wherein the thin-film battery pack (3) is disposed between the glass sheet (6) and the front packaging plate (1), a light-receiving surface of the thin-film battery pack (3) faces the front packaging plate (1), wherein a packaging adhesive film (2) is disposed between the thin-film battery pack (3) and the front packaging plate (1) and the edges between the glass sheet (6) and the front packaging plate (1) are sealed with an adhesive tape.

## Description

### CROSS REFERENCE

This application is based upon and claims priority to Chinese Patent Application No. 201720562486.7, filed on May 19, 2017, the entire contents thereof are incorporated herein by reference.

### TECHNICAL FIELD

The present disclosure relates to solar cell technology, in particular to a thin-film battery photovoltaic module.

### BACKGROUND

With the development of solar cell technology, photovoltaic modules made of CIGS thin-film batteries are increasingly used. In the existing CIGS thin-film batteries, the front packaging plate and the back plate are both made of glass, and are both provided with a POE packaging adhesive film (i.e., double adhesive films), and the edges between the front packaging plate and back plate are sealed with a butyl adhesive tape. In such a packaging method, when the temperature changes drastically, the thermal expansion and contraction of the glass sheet and the front packaging plate glass may cause a tensile force or a squeezing force on the chip in the CIGS thin-film battery, causing serious damage to the chip, thereby affecting the lifetime of the photovoltaic module. In addition, the solar cells in the related art are also packaged with glass on both front and back sides. In order to meet the packaging requirements, the requirements for glass flatness are very high, and the float glass processing technology is required. Therefore, there are high level requirements for the processing technology.

### SUMMARY

The first aspect of the present disclosure provides a thin-film battery photovoltaic module, comprising a glass sheet, a front packaging plate and a thin-film battery pack. The thin-film battery pack is disposed between the glass sheet and the front packaging plate, and a light-receiving surface of the thin-film battery pack faces the front packaging plate; and a packaging adhesive film is disposed between the thin-film battery pack and the front packaging plate, and the edges between the glass sheet and the front packaging plate are sealed with an adhesive tape.

In the thin-film battery photovoltaic module as described above, optionally, the front packaging plate is a glass material or an ETFE film material.

In the thin-film battery photovoltaic module as described above, optionally, the packaging adhesive film is a POE film.

In the thin-film battery photovoltaic module as described above, optionally, a diode string, a connecting piece and a busbar are disposed between the thin-film battery pack and the glass sheet.

In the thin-film battery photovoltaic module as described above, optionally, an insulating layer is disposed between the thin-film battery pack and the diode string, the connecting piece and the busbar.

In the thin-film battery photovoltaic module as described above, optionally, a junction box is provided, wherein the busbar is inserted into the junction box after passing through the glass sheet.

In the thin-film battery photovoltaic module as described above, optionally, the busbar passes through an outlet, which is located on the glass sheet or between the glass sheet and the front packaging plate.

In the thin-film battery photovoltaic module as described above, optionally, a sealant is disposed at a position of the outlet.

In the thin-film battery photovoltaic module as described above, optionally, the adhesive tape is a butyl adhesive tape.

The second aspect of the present disclosure provide a thin-film battery photovoltaic module, comprising a glass sheet, a front packaging plate and a thin-film battery pack in a stacked manner, wherein the thin-film battery pack is disposed between the glass sheet and the front packaging plate, the thin-film battery pack includes a light-receiving surface which faces the front packaging plate; wherein, the thin film battery photovoltaic module further comprises a component layer which is disposed on the other side of the thin-film battery pack opposite to the light-receiving surface, and the component layer and the glass sheet are packaged, the thin-film battery pack and the front packaging plate are packaged with a packaging adhesive film.
The component layer may comprise a diode string, a connecting piece, and a busbar, and the edges between the glass sheet and the front packaging plate are sealed with an butyl adhesive tape.

### BRIEF DESCRIPTION OF THE DRAWINGS

FIG. 1 is a schematic structural diagram of a thin-film battery photovoltaic module according to an embodiment of the present disclosure;
FIG. 2 is a sectional view of a thin-film battery photovoltaic module provided according to an embodiment of the present disclosure.

### Description of the reference numerals:

1 - Front packaging plate; 2 - Packaging adhesive film; 3 - Thin-film battery pack; 4 - Insulating layer; 5 - Component layer; 6 - glass sheet; 7 - Junction box

### DETAILED DESCRIPTION

The embodiments of the present disclosure are described in detail below, and examples of the embodiments are shown in the accompanying drawings, wherein the same or similar reference numerals denote the same or similar elements or elements having the same or similar functions throughout. The embodiments described below with reference to the drawings are exemplary, are used to explain the present disclosure only, and not intended to limit the present disclosure.

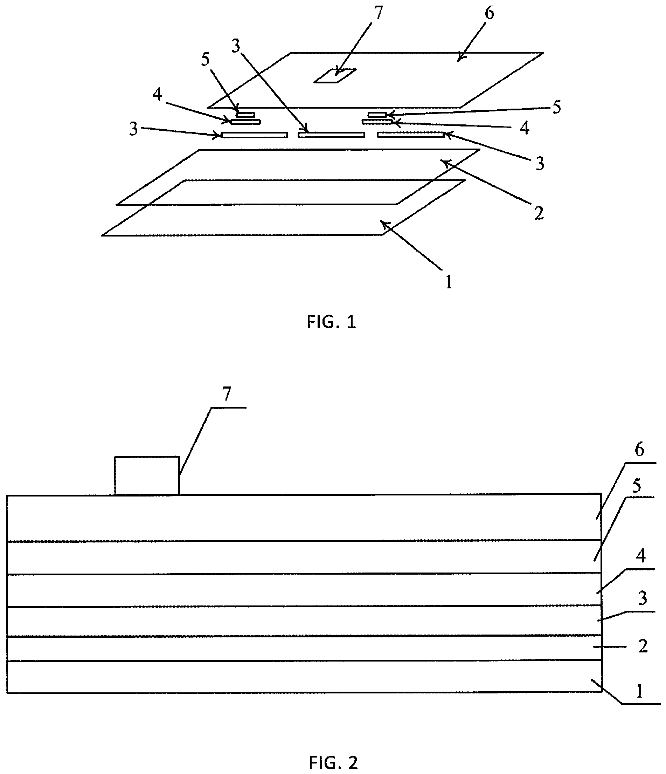

FIG. 1 is a schematic structural diagram of a thin-film battery photovoltaic module according to an embodiment of the present disclosure, and FIG. 2 is a sectional view of a thin-film battery photovoltaic module according to an embodiment of the present disclosure.

The embodiment of the present disclosure provides a thin-film battery photovoltaic module, comprising a glass sheet 6, a front packaging plate 1, and a thin-film battery pack 3. The thin-film battery pack 3 is disposed between the glass sheet 6 and the front packaging plate 1, and a light-receiving surface of the thin-film battery pack 3 faces the front packaging plate 1. A packaging adhesive film 2 is disposed between the thin-film battery pack 3 and the front packaging plate 1. The packaging adhesive film 2 may be a POE film or a film made of other materials.

In an embodiment, the front packaging plate 1 may be made of glass, i.e., a front glass packaging plate, and constitutes a double glass module together with the glass sheet 6 and the thin-film battery pack 3. In the embodiment, since the adhesive film on the side of the glass sheet 6 in the related art is omitted, the cost and product weight are reduced.
In another embodiment of the present disclosure, while omitting the adhesive film on the side of the glass sheet 6, the front packaging plate 1 may also be made ethylene-tetrafluoroethylene copolymer (ETFE) film material, and the ETFE film, the glass sheet 6 and the thin-film battery pack 3 constitute a photovoltaic module. In the embodiment, since the front packaging plate is made of the ETFE film material and only the back plate is made of glass material, the phenomena of different expansion when the front plate and the back plate are both glass do not occur. The extent to which a chip in a thin-film solar cell is stretched or squeezed during thermal expansion and contraction is reduced. Meanwhile, the structure does not require high flatness of the glass, and does not require the use of float glass, which simplifies the processing technology.

A diode string, a connecting piece, a busbar and the like are provided in the component layer 5 between the thin-film battery pack 3 and the glass sheet 6. Optionally, by packaging each component in the component layer 5 on the glass sheet 6, the adhesive film between the component layer 5 and the glass sheet 6 can be omitted. Alternatively, the adhesive film between the component layer 5 and the glass sheet 6 may be directly omitted, and the component layer, the insulating layer, and the thin-film battery pack stacked between the two are sealed with an adhesive tape at the edges between the glass sheet and the front packaging plate. The arrangement of the diode string, the connecting piece and the busbar is the same as the related art and will not be described here. Those skilled in the art can understand that the diode string, the connecting piece and the busbar are independent components, respectively. In the schematic diagram shown in this embodiment, it is represented by the component layer 5.
In order to increase the stability, the chips inside the thin-film photovoltaic module can be connected by a diode string and fixed on the connecting piece.

In order to insulate the diode string, the connecting piece, and the busbar from the thin-film battery pack 3, an insulating layer 4 may be disposed between the thin-film battery pack 3 and the component layer 5.

The thin-film battery photovoltaic module provided according to the embodiment of the present disclosure may include a junction box 7, and the aforesaid busbar may be inserted into the junction box 7 after passing through the glass sheet 6. Optionally, the busbar may pass through an outlet, which is located on the glass sheet 6 or between the glass sheet 6 and the front packaging plate 1, and the outlet may be sealed with a sealant. Referring to FIGs. 1 and 2, in the present embodiment, the outlet is located on the glass sheet 6. The above sealant can use butyl adhesive, which has excellent versatility and good sealing performance.

The edges between the glass sheet 6 and the front packaging plate 1 may be sealed with an adhesive tape. The adhesive tape can be a conventional adhesive tape in the related art or a butyl adhesive tape. As the edges of the thin-film battery photovoltaic module are sealed, the internal structure is vacuumed. The clamping force generated by the vacuum makes the chip and the glass sheet relatively fixed, achieving the effect of stability and sealing.
Compared with the related art using the double-layer adhesive film, the thin-film battery photovoltaic module provided by the above embodiment of the present disclosure only provides the packaging adhesive film 2 between the thin-film battery pack 3 and the front packaging plate 1, omitting the adhesive film between the glass sheet 6 and the component layer 5, thereby reducing he production cost and product weight. In addition, on the basis of omitting the adhesive film on the side of glass sheet 6, the front packaging plate is made of the ETFE film material and only the back plate is made of glass material, the phenomena of different expansion when the front plate and the back plate are both glass do not occur. The extent to which a chip in a thin-film solar cell is stretched or squeezed during thermal expansion and contraction is reduced. Meanwhile, the structure does not require high flatness of the glass, and does not require the use of float glass, which simplifies the processing technology.

The structures, features, and effects of the present disclosure are described in detail based on the embodiments shown in the drawings. The above description is only the preferred embodiments of the present disclosure, but the present disclosure does not limit the scope of implementation as shown in the drawings. Any changes made according to the concept of the present disclosure, or equivalent embodiments that are modified to equivalent changes, should still fall within the protection scope of the present disclosure if they do not go beyond the spirit covered by the description and the drawings.

## Claims

1. A thin-film battery photovoltaic module, comprising a glass sheet, a front packaging plate and a thin-film battery pack, wherein the thin-film battery pack is disposed between the glass sheet and the front packaging plate, and a light-receiving surface of the thin-film battery pack faces the front packaging plate; and
wherein a packaging adhesive film which is disposed between the thin-film battery pack and the front packaging plate, and edges between the glass sheet and the front packaging plate are directly sealed with an adhesive tape.

2. The thin-film battery photovoltaic module according to claim 1, wherein the front packaging plate is a glass material or an ETFE film material.

3. The thin-film battery photovoltaic module according to claim 1, wherein the packaging adhesive film is a POE film.

4. The thin-film battery photovoltaic module according to claim 1, wherein a diode string, a connecting piece, and a busbar are disposed between the thin-film battery pack and the glass sheet.

5. The thin-film battery photovoltaic module according to claim 4, wherein an insulating layer is disposed between the thin-film battery pack and the diode string, the connecting piece and the busbar.

6. The thin-film battery photovoltaic module according to claim 5, further comprising a junction box, wherein the busbar is inserted into the junction box after passing through the glass sheet.

7. The thin-film battery photovoltaic module according to claim 6, wherein the busbar passes through an outlet, which is located on the glass sheet or between the glass sheet and the front packaging plate.

8. The thin-film battery photovoltaic module according to claim 7, wherein the outlet is sealed with a sealant.

9. The thin-film battery photovoltaic module according to claim 1, wherein the adhesive tape is a butyl adhesive tape.

10. The thin-film battery photovoltaic module according to claim 2, wherein the packaging adhesive film is a POE film.

11. The thin-film battery photovoltaic module according to claim 2, wherein a diode string, a connecting piece, and a busbar are disposed between the thin-film battery pack and the glass sheet.

12. The thin-film battery photovoltaic module according to claim 2, wherein the edges between the glass sheet and the front packaging plate are sealed with an adhesive tape.

13. The thin-film battery photovoltaic module according to claim 12, wherein the adhesive tape is a butyl adhesive tape.

14. A thin-film battery photovoltaic module, comprising a glass sheet, a front packaging plate and a thin-film battery pack in a stacked manner, wherein the thin-film battery pack is disposed between the glass sheet and the front packaging plate, the thin-film battery pack includes a light-receiving surface which faces the front packaging plate;
wherein, the thin film battery photovoltaic module further comprises a component layer which is disposed on the other side of the thin-film battery pack opposite to the light-receiving surface, and the component layer and the glass sheet are packaged, the thin-film battery pack and the front packaging plate are packaged with a packaging adhesive film.

15. The thin-film battery photovoltaic module according to claim 14, wherein the component layer comprise a diode string, a connecting piece, and a busbar, and the edges between the glass sheet and the front packaging plate are sealed with a butyl adhesive tape.
